# EUROPEAN PATENT APPLICATION

(11) **EP 1 669 964 A1**
(43) Date of publication of application: **14.06.2006**
(21) Application number: 04788260.0
(22) Date of filing: 28.09.2004
(51) Int. Cl.: G09F 9/00, H05B 33/02, H05B 33/14

(54) **MULTILAYER BODY FOR FORMING BASE WITH WIRING, BASE WITH WIRING, AND METHODS FOR MANUFACTURING THOSE**

(30) Priority: 30.09.2003 JP 2003340283
(71) Applicant: ASAHI GLASS COMPANY LTD., Tokyo 100-8405 (JP); Pioneer Corporation, Tokyo 153-8654 (JP); Tohoku Pioneer Corporation, Tendo-shi, Yamagata 994-8585 (JP); Asahi Glass Fine Techno Co., Ltd., Yonezawa-shi, Yamagata 9921128 (JP)
(72) Inventor: NAGAYAMA, Kenichi, Tsurugashima-shi, Saitama 3502288 (JP); SHIRAHATA, Kunihiko, Yonezawa-shi, Yamagata 9921128 (JP); KITAJIMA, Takayuki, Yonezawa-shi, Yamagata 9921128 (JP); KOMADA, Masaki, Yonezawa-shi, Yamagata 9921128 (JP); NAKAJIMA, Yusuke, Yonezawa-shi, Yamagata 9921128 (JP); HIRUMA, Takehiko Asahi Glass Fine Techno Co., Ltd., Yonezawa-shi, Yamagata 9921128 (JP); SAIKI, Hitoshi Asahi Glass Fine Techno Co., Ltd., Yonezawa-shi, Yamagata 9921128 (JP)
(74) Representative: Müller-Boré & Partner Patentanwälte
(86) International application number: PCT/JP2004/014193
(87) International publication number: WO 2005/031681

(57) **Abstract**

A laminate for forming a substrate with wires in which a silver type material is used for a conductor layer and the layer is covered with a conductive protection layer for protection, the laminate for forming a substrate with wires exhibiting an extremely low contact resistance between the conductive protection layer and a cathode superposed thereon, is presented.

A laminate for forming a substrate with wires, which comprises a substrate, a conductor layer comprising silver or a silver alloy, formed on the substrate, and a conductive protection layer comprising indium zinc oxide, formed on the conductor layer to cover the conductor layer, wherein the conductive protection layer is a conductive protection layer formed by sputtering in an atmosphere wherein the oxidizing gas content in the sputtering gas is not more than 1.5 vol%.

## Description

### TECHNICAL FIELD

The present invention relates to a substrate with wires used for an electrode arrangement for a flat panel display such as an organic electroluminescence (organic EL) element display or the like, a method for producing the same, a laminate for forming a substrate with wires used for such substrate and a method for producing the same. The laminate for forming a substrate with wires means a laminate as a material for forming a substrate with wires.

### BACKGROUND ART

There has been an increased demand for the flat panel display with the progress of advanced information technology in recent years. In particular, a self-luminescence type organic EL element display permitting low voltage driving has been attracting attention as the display of next generation in recent years. The organic EL element has the basic structure that organic layers such as a hole transport layer, a light emission layer, an electron transport layer and so on are provided in this order from an anode side between a transparent electrode (anode) made of a tin-doped indium oxide (ITO) and a metal electrode (cathode).

As a technique concerning the organic EL element, there is publication for a method for forming an IZO film using a specified IZO (an oxide comprising In and Zn) sputtering target in an atmosphere of Ar gas or a gas mixture of (Ar+1%O₂) (see Patent Document 1).

Further, there is publication for a laminate having an Ag type film characterized in that between a substrate and an Ag type film made of an Ag type material, an oxide film of the Ag type material is interposed, wherein there is description of heating the substrate and conducting sputtering in a gas mixture of Ar gas and O₂ gas to thereby form the Ag type film (see Patent Document 2).

Further, there is publication for a thin film electrode of Ag alloy wherein on the surface of a thin film of a specified Ag alloy, an adhesive layer of wetness improving coating, made of a metal oxide or a good conductive metal is provided (see Patent Document 3).

Further, Patent Document 4 describes a substrate with a transparent conductive film for a display element wherein the transparent conductive film covers the main surface of the transparent electrode, and the transparent conductive film comprises a first antireflection layer, a metal layer and a second antireflection layer superposed sequentially in this order on the substrate, the metal layer being a layer comprising silver as the measure component and palladium in a content of not less than 0.2 but not more than 3.0 in terms of wt%. If the palladium content is less than 0.2 wt%, the improvement of the water resistance of the silver layer would decrease remarkably, and if it exceeds 3.0 wt%, the specific resistance of the silver layer becomes greater than 10 µ Ωcm, according to the publication (see Patent Document 4).

It is necessary to reduce further the resistance of the ITO layer in the current organic EL elements in order to achieve a colored display or a high precision structure. However, the attempt to reduce the resistance of the ITO layer has now being approaching the limit. Therefore, the reduction of the resistance of the element circuits has been achieved, in many cases, substantially with a wire arrangement of a metal of low resistance such as aluminum, an aluminum ally or the like in combination with the electrode made of the ITO layer.

However, when an aluminum type material such as aluminum, an aluminum alloy or the like is used, it was difficult to reduce the specific resistance below about 4 µΩ·cm. Further, there was a problem that electrochemical reaction to ITO took place easily.

In order to solve the above problem, there is the proposal that a silver type material having a lower resistance than the aluminum type material be used (see Patent Document 5). Specifically, Patent Document 5 describes a wire arrangement of silver or a silver alloy, which comprises a conductor layer of silver or a silver alloy and a conductive protection layer having conductivity, laminated so as to cover the conductor layer of silver or a silver alloy.

In the manufacturing process of an organic EL element, ultraviolet/ozone (UV/O₃) cleaning or an oxygen (O₂) plasma treatment is conducted to improve the luminous efficiency of the element. In the conventional technique, however, since the silver type material has a low oxidation resistance, it was oxidized due to the UV/O₃ cleaning or the O₂ plasma treatment so that the specific resistance increases remarkably, and therefore, such material could not be used.

On the other hand, in the wire arrangement of silver or a silver alloy disclosed in Patent Document 5, a silver type material is used for the conductor layer and the conductive protection layer is formed to cover it for protection, whereby the silver type material that has been difficult for practical application could be used practically.
Patent Document 1: Pamphlet of international publication 00/68456
Patent Document 2: JP-A-2003-170524
Patent Document 3: JP-A-2003-55721
Patent Document 4: JP-A-9-283866
Patent Document 5: JP-A-2003-36037

### DISCLOSURE OF THE INVENTION

### OBJECT TO BE ACCOMPLISHED BY THE INVENTION

The inventors of this patent application have noted that in the wire arrangement of silver or a silver alloy described in Patent Document 5, there is still room for reducing the contact resistance between the conductive protection layer and the cathode superposed thereon. They have had such idea that the voltage necessary to drive a flat panel display can be reduced by using a specified conductive protection layer, and then, the temperature rise in and the deterioration of the flat panel display can be prevented.

Thus, the object of the present invention is to provide a laminate for forming a substrate with wires in which a silver type material is used for a conductor layer and the layer is covered with a conductive protection layer for protection, the laminate for forming a substrate with wires exhibiting an extremely low contact resistance between the conductive protection layer and the cathode superposed thereon.

### MEANS TO ACCOMPLISH THE OBJECT

The inventors have studied concentratedly on the technique described in Patent Document 5. As a result, the present invention has been completed by finding that the contact resistance between the conductive protection layer and the cathode superposed thereon can be reduced by using a specified conductive protection layer.

Namely, this application is to present the following (1) through (6).
(1) A laminate for forming a substrate with wires, which comprises a substrate, a conductor layer comprising silver or a silver alloy, formed on the substrate, and a conductive protection layer comprising indium zinc oxide, formed on the conductor layer to cover the conductor layer, wherein the conductive protection layer is a conductive protection layer formed by sputtering in an atmosphere wherein the oxidizing gas content in the sputtering gas is not more than 1.5 vol%.
(2) The laminate for forming a substrate with wires according to the above-mentioned (1), wherein the above conductor layer comprises a silver/palladium alloy.
(3) The laminate for forming a substrate with wires according to the above-mentioned (1) or (2), which has an adhesive layer comprising at least one member selected from the group consisting of indium zinc oxide, silver oxide, silver alloy oxide, molybdenum oxide, molybdenum alloy oxide, copper alloy oxide and nickel alloy oxide, between the substrate and the conductor layer.
(4) A substrate with wires having a flat patterning applied to the laminate for forming a substrate with wires as defined in any one of the above-mentioned (1) to (3).
(5) A process for producing a laminate for forming a substrate with wires, which comprises a step of forming a conductor layer comprising silver or a silver alloy on a substrate by sputtering and a step of forming a conductive protection layer comprising indium zinc oxide by sputtering in an atmosphere wherein the oxidizing gas content is not more than 1.5 vol% on the conductor layer to cover the conductor layer, thereby to obtain a laminate for forming a substrate with wires.
(6) A process for producing a substrate with wires, which comprises applying a flat pattering by a photolithographic method on the laminate for forming a substrate with wires obtainable by the process for producing a laminate for forming a substrate with wires as defined in the above-mentioned (5).

### EFFECTS OF THE INVENTION

In the present invention, when a conductor layer including a silver type material and a conductive protection layer covering the same are used, the contact resistance between the conductive protection layer and the cathode can be reduced. Accordingly, the voltage necessary to drive a flat panel display can be reduced, and then, temperature rise in and the deterioration of the flat panel display can be prevented.

### BRIEF DESCRIPTION OF THE DRAWINGS

Fig. 1: A plan view showing an example of a substrate with wires according to the present invention, which is obtainable by conducting a flat patterning to the laminate of the present invention.
Fig. 2: A cross-sectional view taken along a line II-II in Fig. 1.
Fig. 3: A cross-sectional view taken along a line III-III in Fig. 1.
Fig. 4: A plan view of a sample to measure the contact resistance in Example.

### MEANING OF SYMBOLS

- 1:: Glass substrate
- 2:: Wire (supplemental electrode)
- 2a:: Conductor layer
- 2b:: Conductive protection layer
- 3:: ITO anode
- 4:: Organic layer
- 5:: Al cathode
- 6:: Sealed can
- 10:: Sample for measurement
- 12,12', 16,16':: Enlarged portion
- 14,18:: Strip-like pattern
- 20:: Crossing portion

### BEST MODE FOR CARRYING OUT THE INVENTION

In the following, the present invention will be described in detail.

The laminate for forming a substrate with wires of the present invention (hereinbelow, referred simply to "the laminate of the present invention") comprises a substrate, a conductor layer comprising silver or a silver alloy formed on the substrate and a conductive protection layer comprising indium zinc oxide, formed on the conductor layer to cover the conductor layer.

As the substrate, there are a transparent or opaque glass substrate, ceramic substrate, plastic substrate, metal substrate and so on. The substrate has generally a flat plate-like shape, but may have a curved plane or another different shape.

When it is used for an organic EL element having a structure that light is emitted from a substrate side, it is preferred that the substrate is transparent, in particular, is a glass substrate from viewpoints of strength and heat resistance. As the glass substrate, a transparent colorless soda lime glass substrate, quartz glass substrate, borosilicate glass substrate, non-alkali glass substrate may be mentioned. When it is used for an organic EL element, the thickness of the glass substrate is from 0.2 to 1.5 mm from viewpoints of strength and transmittance.

The conductor layer formed on the substrate contains silver or a silver alloy. The silver alloy is an alloy comprising silver and at least one of optional materials. As other materials than the silver alloy to be used palladium, copper, ruthenium, gold, magnesium, zinc, indium and a tin oxide may be mentioned, for example. The mixing rate of these materials is not in particular limited. However, when the mixing rate is larger, the specific resistance of the conductor layer generally increases, and therefore, it is preferably not more than 10 mass% based on the total amount of the silver alloy.

In particular, a silver alloy containing palladium is preferred as the material for the conductor layer. Palladium has an effect of improving the corrosion resistance of the conductor layer and an effect of improving the adhesiveness between the conductor layer and the substrate adjacent thereto. As the silver alloy containing palladium, a silver/palladium alloy and a silver/palladium/copper alloy may be mentioned, for example. In particular, the silver/palladium alloy is preferred because it has a better specific resistance than the silver/palladium/copper alloy. The palladium content in the silver alloy containing palladium is preferably from 0.5 to 2 atomic%. When the content is within this range, the corrosion resistance and the adhesiveness are excellent and the specific resistance is preferably low. The palladium content is in particular preferably from 0.7 to 1.5 atomic%.

Specifically, 99Ag-1Pd (a silver alloy containing 1 atomic% of palladium), 98.1Ag-0.9Pd-1Cu (a silver alloy containing 0.9 atomic% of palladium and 1 atomic% of copper) may preferably be mentioned, for example.

The thickness of the conductor layer is preferably from 250 to 500 nm. This range of the thickness increases conductivity. More preferably, the thickness of the conductor layer is from 250 to 400 nm. When the thickness of the conductive protection layer, described layer, is 25 nm or more, there is an advantage not to cause overhanging due to the etching treatment in a photolithographic method.

In forming the conductor layer, the forming method is not in particular limited. For example, a sputtering method, a vapor deposition method or a CVD method may be used. In particular, the sputtering method is preferred.

When the sputtering method is used, the following process is carried out preferably. Namely, a silver alloy target is fixed to the cathode of a d.c. magnetron sputtering device, and a substrate is fixed to the substrate holder. Then, air in the deposition chamber is evacuated and an Ar gas is introduced as sputtering gas. The sputtering pressure is preferably from 0.1 to 2 Pa and the back pressure is preferably from 1x10⁻⁶ to 1x10⁻² Pa. The substrate temperature is preferably from 150 to 250°C. By heating the substrate at the time of forming the film, the adhesiveness increases and the specific resistance decreases.

The conductive protection layer formed on the conductor layer contains indium zinc oxide (IZO). The conductive protection layer is formed to cover the conductor layer. Since IZO has excellent oxidation resistance, it is difficult to be oxidized, and further the conductor layer is protected by the conductive protection layer. Accordingly, the increase of the specific resistance can be prevented even when the UV/O₃ cleaning or O₂ plasma treatment is conducted.

Further, IZO has conductivity. Accordingly, not only the conductor layer but also the conductive protection layer serve as supplementary electrodes.

The content of ZnO in IZO in the conductive protection layer is preferably from 5 to 15 mass% based on the total amount of In₂O₃ and ZnO.

In the present invention, the conductive protection layer is formed by sputtering in an atmosphere wherein the oxidizing gas content in the sputtering gas is not more than 1.5 vol%.

There has been known as common knowledge for a person skilled in the art that in order to reduce the specific resistance of an obtainable oxide film in a case of forming the oxide film by using an oxide target by the sputtering method, it is effective to conduct the sputtering in an atmosphere containing an oxidizing gas such as oxygen gas or the like. In order to reduce the specific resistance of the obtainable oxide film and increase the transmittance, therefore, the oxide film has usually been formed by sputtering in the atmosphere containing the oxidizing gas.

On the other hand, the inventors have paid attention to the contact resistance between the conductive protection layer and the cathode rather than the specific resistance. Then, surprisingly, on contrary to the common sense of the conventional technique, the inventors have found that the contact resistance between the conductive protection layer and the cathode can be reduced when the oxidizing gas content in a sputtering atmosphere (sputtering gas) is less than the predetermined range although the specific resistance of the obtainable IZO is larger than that of the case using the atmosphere containing the oxidizing gas, and further, the resistance can be reduced as a whole. Thus, the present invention has been achieved by finding that this is very useful.

Patent Document 1 describes the method for forming an IZO film by using a specific IZO sputtering target in an atmosphere of Ar gas or a gas mixture of (Ar+1%O₂).

However, the technique described in Patent Document 1 is merely to form the film in an atmosphere of Ar gas or a gas mixture of Ar+1%O₂ in order to show that Sn is preferred as the metal to be added to IZO and that there is no influence to the film formation even though Sn is added, and there is no statement at all as to the reason for selecting the atmosphere of Ar gas or a gas mixture of (Ar+1%O₂). Further, the addition of Sn may cause a problem on patterning speed.

With respect to the sputtering atmosphere in forming the conductive protection layer, there is in particular no restriction as long as the oxidizing gas content is not more than 1.5 vol%. The oxidizing gas content is preferably not more than 1.0 vol%, more preferably, not more than 0.5 vol%, most preferably, substantially zero.

As the oxidizing gas, oxygen gas, ozone gas, carbon dioxide gas and a gas mixture thereof (e.g., a gas mixture of oxygen and ozone) may be mentioned, for example.

As the gas, other than the oxidizing gas contained in the sputtering atmosphere, there is an inert gas such as helium, neon, argon, krypton or xenon. In particular, argon is preferred from viewpoints of economic efficiency and easy discharge. These inert gases can be used independently or a mixture of at least two kinds.

With respect to other conditions of sputtering in forming the conductive protection layer, there is in particular no limitation. However, it is preferred to form the film by using the same sputtering pressure, back pressure and substrate temperature as for the conductor layer and using the IZO target.

The thickness of the conductive protection layer is preferably at least 25 nm but not more than 70 nm, more preferably not more than 50 nm. If the thickness of the conductive protection layer is too small, it dissolves at the time of reworking in the failure of patterning because IZO has a fairly high solubility to alkali, whereby the protecting performance may be lost. On the other hand, when the thickness of the conductive protection layer is too large, efficiency of patterning decreases. Further, since the etching speed of IZO is low (for instance, when a silver/palladium alloy is used for the conductor layer, the etching speed of IZO is about 1/10), the manufacturing efficiency decreases.

As a preferred aspect of the present invention, an adhesive layer is provided between the substrate and the conductor layer, the adhesive layer comprising at least one member selected from the group consisting of IZO, silver oxide, silver alloy oxide, molybdenum oxide, molybdenum alloy oxide, copper alloy oxide and nickel alloy oxide. It is in particular preferred that the adhesive layer is a layer containing a nickel/molybdenum alloy oxide from the viewpoint of adhesiveness.

When the laminate of the present invention has such adhesive layer, the adhesiveness between the substrate and the conductor layer is improved.

The thickness of the adhesive layer is preferably from 5 to 40 nm. If the thickness of the adhesive layer is too small, a sufficient adhesiveness can not be expected. On the other hand, if the thickness is too large, manufacturing efficiency decreases.

It is preferable that the adhesive layer is formed by sputtering in an atmosphere containing an oxidizing gas. As the oxidizing gas, it is possible to use any of the gases described above. As other conditions for sputtering in forming the adhesive layer, it is preferred to form the film by using the same sputtering gas, sputtering pressure, back pressure and substrate temperature as for the conductor layer.

The laminate of the present invention may have a silica layer between the substrate and the conductor layer (or the adhesive layer when it is formed). Generally, the silica layer is formed by sputtering a silica target. When a glass substrate is used as the substrate, the silica layer prevents the deterioration of the conductor layer, which is caused by the movement of an alkali component in the glass substrate into the conductor layer. It is preferable that the film thickness is from 5 to 30 nm.

The laminate of the present invention may be provided with an ITO layer between the substrate (or the silica layer when it is formed) and the conductor layer (or the adhesive layer when it is formed). The ITO layer can be used as a transparent electrode.

The ITO layer can be formed on the substrate by using, for instance, an electron beam method, a sputtering method, an ion plating method or the like. In particular, it is preferably formed by sputtering, using an ITO target containing SnO₂ in an amount of 3 to 15 mass% based on the total amount of In₂O₃ and SnO₂. As the sputtering atmosphere, a gas mixture of O₂ and Ar is preferably used wherein the O₂ gas concentration is preferably from 0.2 to 2 vol%.

The film thickness of the ITO layer is preferably from 50 to 300 nm, and the SnO₂ content in the formed film is preferably the same as the SnO₂ content in the ITO target.

In the laminate of the present invention, a silver type material is used for the conductor layer and the conductive protection layer is formed to cover the conductor layer for protection. Further, since the contact resistance between the conductive protection layer and the cathodes superposed thereon is extremely low, it is possible to reduce the voltage necessary to drive the flat panel display and it can be expected to prevent temperature rise in and the deterioration of the flat panel display.

The laminate thus obtained according to the present invention is subjected to a flat patterning to thereby form the substrate with wires of the present invention. The method for producing the substrate with wires of the present invention is not in particular limited, however, the method of etching according to a photolithographic method is preferably employed. In the following, the method will be explained in detail.

A photoresist is applied onto the conductive protection layer as the outermost surface of the laminate of the present invention, a wire pattern is printed on its surface and unnecessary portions of the conductor layer and the conductive protection layer are removed with an etching solution according to the photoresist pattern, whereby the substrate with wires is formed. The etching solution is preferably an aqueous solution of acid such as phosphoric acid, nitric acid, acetic acid, sulfuric acid or hydrochloric acid, or a mixture of these components, ammonium cerium nitrate, perchloric acid or a mixture of these components. In particular, a mixed solution of water and phosphoric acid, nitric acid, acetic acid and sulfuric acid, or a mixed solution of water and phosphoric acid, nitric acid and acetic acid is preferred.

When the laminate of the present invention has the ITO layer, the conductor layer and the conductive protection layer may be removed together with the ITO layer with an etching liquid. Or, the conductor layer and the conductive protection layer may be previously removed and the ITO layer be removed separately. Or, the ITO layer may be previously patterned; the conductor layer and the conductive protection layer be sputtered, and then, portions of the conductor layer and the conductive protection layer excluding wire portions may be removed.

In the following, a preferred example of the production of an organic EL element display by using the substrate with wires formed according to the present invention, such substrate being prepared by using the laminate of the present invention, will be described with reference to the drawing. However, the present invention is not restricted thereto.

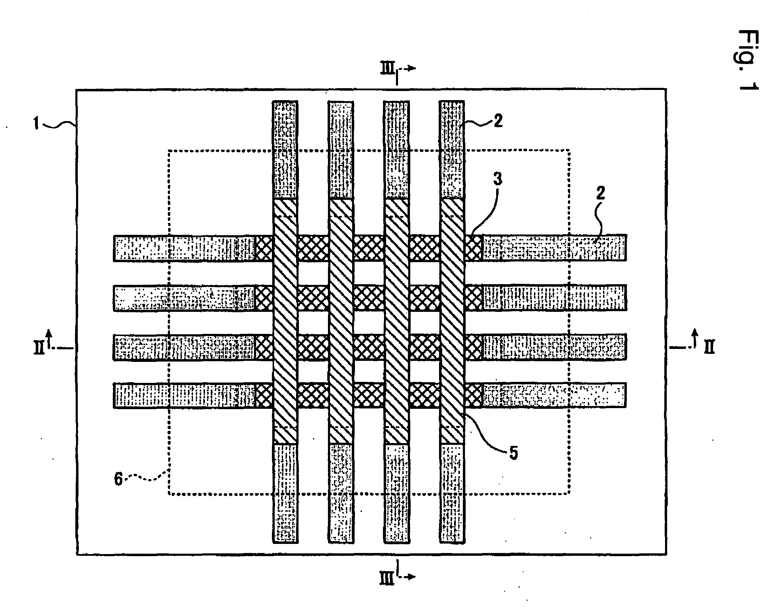

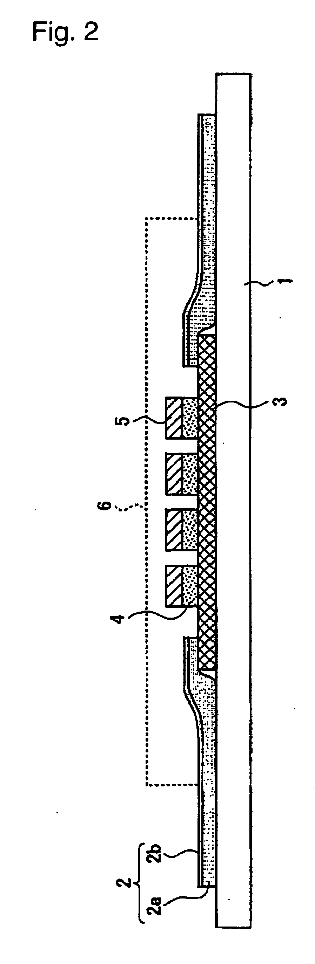

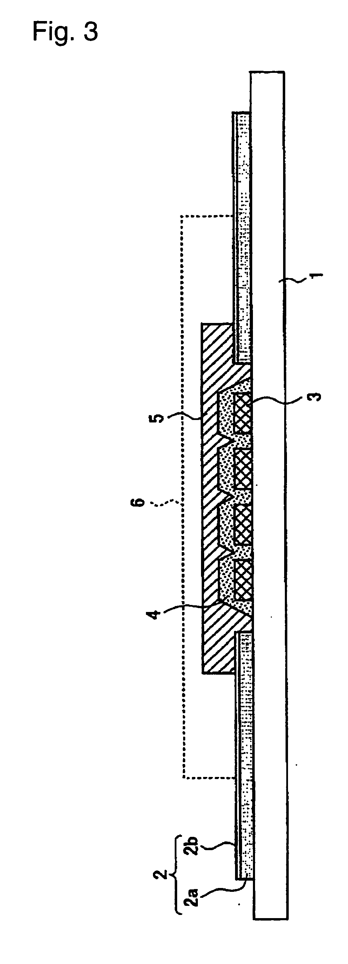

Fig. 1 is a plan view showing an embodiment of the substrate with wires of the present invention, which is obtainable by patterning the laminate of the present invention in its surface, and Fig. 2 is a cross-sectional view taken along a line II-II in Fig. 1 and Fig. 3 is a cross-sectional view taken along a line III-III in Fig. 1.

First, an ITO layer is formed on a glass substrate 1. the ITO layer may be formed on the entire surface of the glass substrate 1 or may be formed partially thereon. Then, the ITO layer is etched to form an ITO anode 3 in a stripe pattern. Then, a silver/palladium layer as a conductor layer is formed by sputtering. Further, an IZO layer as a conductive protection layer is formed by sputtering on the silver/palladium layer so as to cover the silver/palladium layer in an atmosphere wherein the oxidizing gas content is not more than 1.5 vol%, whereby the laminate of the present invention is obtainable.

On the laminate of the present invention, a photoresist is coated, and unnecessary portions of the silver/palladium layer and the IZO layer are etched to remove the photoresist according to the pattern, whereby wires 2 comprising the conductor layer 2a and the conductive protection layer 2b are formed. Then, cleaning is conducted by irradiating ultraviolet rays and the entirety of the laminate is subjected to UV/O₃ cleaning or an O₂ plasma treatment. In the cleaning by irradiating ultraviolet rays, ultraviolet rays are generally irradiated from an ultraviolet lamp to remove organic matters.

Then, an organic layer 4 comprising a hole transport layer, a light emission layer and an electron transport layer is formed on the ITO anode 3. When a cathode separator (separator) is to be formed, it is formed by photolithography before the organic layer 4 is formed by a vacuum deposition method. Then, an Al cathode 5 as a cathode back-electrode is formed by sputtering so as to cross perpendicularly to the ITO anode 3. Further, the portion surrounded by a broken line in the figure is sealed with resin to form a sealed can 6. Thus, an organic EL element display is obtainable.

Since the substrate with wires of the present invention employs the laminate of the present invention, it is possible to reduce the voltage necessary to drive a flat panel display such as an organic EL element display or the like, and it can be expected to prevent temperature rise in and the deterioration of the flat panel display.

### EXAMPLES

In the following, the present invention will be described specifically by means of Examples. However, the present invention should not be limited thereto. 1-1. Preparation of laminates for forming substrates with wires

### EXAMPLE 1

Soda lime glass substrates having a thickness of 0.7 mm were cleaned and they were fixed on a sputtering device. A high frequency magnetron sputtering method was carried out by using a silica target to form a silica layer having a thickness of 20 nm on the substrates. Thus, substrates with a silica layer were obtained.

Then, on each of the substrates with a silica layer, an ITO layer having a thickness of about 160 nm was formed according to a d.c. magnetron sputtering method by using an ITO target (containing 10 mass% of SnO₂ based on the total amount of In₂O₃ and SnO₂). Thus, substrates with an ITO layer were obtained. The composition of the ITO layer was substantially the same as that of the ITO target.

Further, on each of the substrates with an ITO layer, a 99Ag-1Pd (atomic%) alloy layer having a thickness of about 300 nm was formed as a conductor layer in an atmosphere of Ar gas according to a d.c. magnetron sputtering method by using a silver/palladium alloy target (99Ag-1Pd) (atomic%)). Thus, substrates with a conductor layer were obtained. The conditions of sputtering were 5x10⁻⁴ Pa for back pressure, 0.5 Pa for sputtering pressure and 200°C for film-forming temperature (substrate temperature).

### EXAMPLES 2 to 5

On each of the substrates with a conductor layer obtained in Example 1, an IZO layer as shown in Table 1 was formed as a conductive protection layer by d.c. magnetron sputtering method in an atmosphere of Ar gas by using an IZO target (containing 10.7 mass% of ZnO based on the total amount of In₂O₃ and ZnO). Thus, laminates for forming substrates with wires were obtained. The conditions of sputtering were 0.6 Pa for sputtering pressure, and 200°C for film-forming temperature (substrate temperature). The composition of the IZO layer was substantially the same as that of the IZO target.

### 1-2. Evaluation of UV/O₃ resistance of laminates for forming substrates with wires, etc.

To the substrates with a conductor layer obtained in Example 1 and laminates for forming substrates with wires obtained in Examples 2 to 5, patterning is conducted according to a photolithographic method to form wires having a width of 50 µm. Thus, substrates with wires were obtained. Each etching time in the photolithographic method is shown in Table 1.

Then, evaluation of the UV/O₃ resistance was made as follows.

The evaluation of the UV/O₃ resistance was conducted by observing the wires on the substrates with wires with a microscope, the observed wires having been subjected to a UV/O₃ treatment for 10 min in the UV/O₃ cleaning device manufactured by Takizawa Sangyo K.K. The case that no corrosion was recognized in the wires was evaluated as O, and the case that corrosion was recognized was evaluated as X. Further, the substrates with wires were subjected to an alkali treatment by immersing them in an aqueous solution of 3 mass% of sodium nitrate for 10 min., and then, evaluation of the UV/O₃ resistance was made in the same manner as above. Each UV/O₃ resistance of the substrates without treatment and with the alkali treatment is shown in Table 1.

**TABLE 1**

| Ex. | Layer structure | | Thickness of conductive protection layer immediately after film formation (nm) | Etching time (sec) | UV/O₃ resistance | |
|---|---|---|---|---|---|---|
| | Conductor layer | Conductive protection layer | | | Without treatment | Treatment with alkali |
| 1 | 99Ag-1Pd | - | - | 100 | X | X |
| 2 | 99Ag-1Pd | IZO | 20 | 132 | **○** | X |
| 3 | 99Ag-1Pd | IZO | 30 | 160 | O | O |
| 4 | 99Ag-lPd | IZO | 40 | 195 | O | **○** |
| 5 | 99Ag-1Pd | IZO | 50 | 230 | **○** | **○** |

Table 1 reveals that the substrates having a conductive protection layer (Examples 2 to 5) have excellent UV/O₃ resistance. In particular, when the thickness of the conductive protection layer was in a range of from 30 to 50 nm (Examples 3 to 5), they show excellent UV/O₃ resistance after the alkali treatment. The reason is considered as follows. When the thickness of the conductive protection layer was 20 nm (Example 2), the alkali resistance of IZO used for the conductive protection layer was not high, whereby the conductive protection layer was dissolved in the alkali treatment so that the conductor layer was exposed partially. On the other hand, when the thickness of the conductive protection layer was from 30 to 50 nm (Examples 3 to 5), the conductive protection layers have a sufficient thickness to prohibit the exposure of the conductor layer. 2-1. Preparation of laminates for forming substrates with wires

### EXAMPLES 6 to 8

On each of the substrates with a silica layer obtained in Example 1, a 99Ag-1Pd (atomic%) alloy layer having a thickness of about 380 nm was formed as a conductor layer in an atmosphere of Ar gas according to a d.c. magnetron sputtering method by using a silver/palladium alloy target (99Ag-1Pd (atomic%)) to thereby obtain substrates with a conductor layer. The conditions of sputtering were 5×10⁻⁴ Pa for back pressure, 0.5 Pa for sputtering pressure and 200°C for film-forming temperature (substrate temperature).

On each of the substrates with a conductor layer, an IZO layer having a thickness of about 30 nm was formed as a conductive protection layer according to a d.c. magnetron sputtering method by using an IZO target (containing 10.7 mass% of ZnO based on the total amount of In₂O₃ and ZnO) to obtain laminates for forming substrates with wires. The conditions of sputtering were 0.6 Pa for sputtering pressure and 200°C for film-forming temperature (substrate temperature). As the sputtering gas, an Ar gas (Example 6), an Ar gas containing 1.0 vol% of O₂ gas (Example 7) and an Ar gas containing 2.0 vol% of O₂ gas (Example 8) were used. The composition of the IZO layer was substantially the same as that of the IZO target.

### 2-2. Evaluation of contact resistance between laminates for forming substrates with wires and cathodes

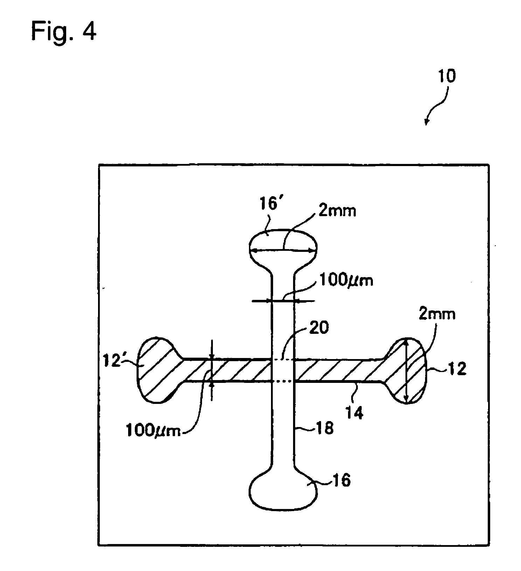

Measured samples 10 shown in Fig. 4 were prepared. To each of the laminates for forming substrates with wires obtained in Examples 6 to 8, wet etching was conducted to dissolve unnecessary portions of the conductor layer and the conductive protection layer so that a strip-like pattern 14 having a width of 100 µm and having enlarged portions 12 and 12' of 2 mm at both ends was formed. Then, an Al layer having a strip-like pattern 18 of 100 µm wide, with enlarged portions 16 and 16' of 2 mm at both ends was formed so as to cross perpendicularly to the above stripe-like pattern, the Al layer being formed by a vacuum deposition method using a lift-off method using, as a mask, a resist formed according to a photolithographic method. Thus, the conductor layer, the conductive protection layer and the Al layer were superposed on the substrate with a silica layer at the crossing portion 20 where two strip-like patterns 14, 18 crossed.

In each measured samples obtained as described above, electrodes were connected to the enlarged portions 12 and 16 and a current was fed across them, and on the other hand, electrodes were connected to the enlarged portions 12', 16' to measure the voltage therebetween. Thus the contact resistance of the portion of 100 µm square between the conductive protection layer and the Al layer at the crossing portion 20 of each measured sample, was measured.

Further, measured samples were prepared by using the same method as described above except that a heat treatment was conducted at 300°C for 60 minutes after the wet etching. On each of the samples, the contact resistance between the conductive protection layer and the Al layer was measured by the same method as described above.

Results are shown in Table 2.

**TABLE 2**

| Ex. | O₂ content in sputtering gas (vol%) | Contact resistance (Ω/□) | |
|---|---|---|---|
| | | Without treatment | Heat treatment |
| 6 | 0.0 | 2.4 | 6.2 |
| 7 | 1.0 | 2.4 | 8.5 |
| 8 | 2.0 | 7.4 | 34.5 |

Table 2 reveals that the contact resistance is small even in any case without treatment and with heat treatment when the oxidizing gas content in the sputtering gas used for sputtering to the conductive protection layer is 0.0 vol% and 1.0 vol% (Examples 6 and 7). On the other hand, the contact resistance was large even in any case without treatment and with heat treatment when the oxidizing gas content in the sputtering gas was 2.0 vol% (Example 8). It is preferable from a practical viewpoint that the increase of the contact resistance before and after the heat treatment is not more than 20 Ω/ 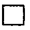 , particularly, 10 Ω/ 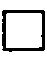 . Further, it is preferable from a practical viewpoint that the contact resistance after the heat treatment is not more than 30 Ω/ 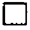 , in particular, 20 Ω/ 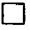 .

### 3. Evaluation of adhesiveness of laminate for forming a substrate with wires

To the laminate for forming a substrate with wires obtained in Example 3, a scratching test was conducted, while increasing the load by using a variable load type scratching test machine (TRYGEAR HHS2000, manufactured by SHINTOH KAGAKU K.K., probe curvature: 0.2 µm) to measure the load with which there occurred separation of the conductor layer and the conductive protection layer. The measurement was conducted 5 times to obtain an average value.

The result is shown in Table 3. When the load causing the separation in this scratching test is at least 50 gf, the adhesiveness of the conductor layer would not be problematic from a practical viewpoint.

**TABLE 3**

| Ex. | Layer structure | | | Load (gf) |
|---|---|---|---|---|
| | Adhesive layer | Conductor layer | Conductive Protection layer | |
| 3 | - | 99Ag-1Pd | IZO | 63 |

Table 3 reveals that the laminate of the present invention exhibits the adhesiveness at the level that is no problem in practical use.

## Claims

1. A laminate for forming a substrate with wires, which comprises a substrate, a conductor layer comprising silver or a silver alloy, formed on the substrate, and a conductive protection layer comprising indium zinc oxide, formed on the conductor layer to cover the conductor layer, wherein the conductive protection layer is a conductive protection layer formed by sputtering in an atmosphere wherein the oxidizing gas content in the sputtering gas is not more than 1.5 vol%.

2. The laminate for forming a substrate with wires according to Claim 1, wherein the above conductor layer comprises a silver/palladium alloy.

3. The laminate for forming a substrate with wires according to Claim 1 or 2, which has an adhesive layer comprising at least one member selected from the group consisting of indium zinc oxide, silver oxide, silver alloy oxide, molybdenum oxide, molybdenum alloy oxide, copper alloy oxide and nickel alloy oxide, between the substrate and the conductor layer.

4. A substrate with wires having a flat patterning applied to the laminate for forming a substrate with wires as defined in any one of Claims 1 to 3.

5. An organic EL element display employing the substrate with wires as defined in Claim 4.

6. A process for producing a laminate for forming a substrate with wires, which comprises a step of forming a conductor layer comprising silver or a silver alloy on a substrate by sputtering and a step of forming a conductive protection layer comprising indium zinc oxide by sputtering in an atmosphere wherein the oxidizing gas content is not more than 1.5 vol% on the conductor layer to cover the conductor layer, thereby to obtain a laminate for forming a substrate with wires.

7. A process for producing a substrate with wires, which comprises applying a flat pattering by a photolithographic method on the laminate for forming a substrate with wires obtainable by the process for producing a laminate for forming a substrate with wires as defined in Claim 6.
